Europäisches Patentamt

European Patent Office

Office européen des brevets

(11) Numéro de publication: **0 464 445 A1**

# DEMANDE DE BREVET EUROPEEN

(21) Numéro de dépôt: **91109905.9**

(22) Date de dépôt: **17.06.91**

(51) Int. Cl.5: **G01R 29/26**, G01R 31/26

(30) Priorité: **22.06.90 FR 9007853**

(43) Date de publication de la demande:
**08.01.92 Bulletin  92/02**

(84) Etats contractants désignés:
**DE FR GB IT**

(71) Demandeur: **ALCATEL ESPACE**
**11, avenue Dubonnet**
**F-92407 Courbevoie Cédex(FR)**

(72) Inventeur: **Zoccarato, Walter**

**3, Impasse des Geais**
**F-31830 Plaisance du Touch(FR)**
Inventeur: **Theron, Bernard**
**112, Jardins de Naubours, Auzielle**
**F-31650 Saint-Orens(FR)**
Inventeur: **Barbaste, Régis**
**2, rue de Roudoulenque**
**F-31120 Portet(FR)**

(74) Mandataire: **Weinmiller, Jürgen et al**
**Lennéstrasse 9 Postfach 24**
**W-8133 Feldafing(DE)**

(54) **Dispositif de mesure de l'effet multipactor par bruit de phase.**

(57)  La présente invention se rapporte à un dispositif de mesure de l'effet multipactor, comprenant :
- en série entre l'entrée, qui reçoit la puissance incidente (Pi), et la sortie qui délivre la puissance de sortie (Ps), un premier coupleur (10), le dispositif à mesurer (11) disposé dans un caisson à vide (12), un second coupleur (13) ;
- et un mélangeur (14) fonctionnant en détection de phase qui est relié, en sa première entrée, à une sortie du premier coupleur, qui permet un prélèvement d'une partie de la puissance incidente (Pi), au travers d'un premier atténuateur (15) et d'un déphaseur (16) et en sa seconde entrée à une sortie du second coupleur, qui permet à un prélèvement d'une partie de la puissance de sortie (Ps), au travers d'un second atténuateur (17), et dont la sortie (Vs) est reliée à un analyseur de spectre (18). Application notamment au domaine spatial.

FIG.1

L'invention concerne un dispositif de mesure de l'effet multipactor par bruit de phase.

Un article de P.F. Clancy intitulé "Multipactor control in microwave space systems" paru dans "Microwave Journal" (mars 1978) décrit les conditions physiques donnant naissance au mécanisme de défaut multipactor dans des systèmes spatiaux hyperfréquences : notamment les niveaux de puissance, les gammes de fréquence et les largeurs de fentes. Cet article décrit, notamment à la page 82, la mesure de l'effet multipactor par détection de bruit. Mais cette détection de bruit se fait au pied de la porteuse et non par le bruit de phase, d'où un problème de sensibilité de la mesure qui dépend :

- de la fréquence d'analyse ;
- de l'excursion en fréquence ;
- de la bande d'analyse ;
- du facteur de bruit des appareils de mesure.

Enfin la figure correspondante ne fait apparaitre que la mesure sur la puissance réfléchie.

L'invention a pour objet de résoudre le problème précité.

Elle propose, à cet effet, un dispositif de mesure de l'effet multipactor, caractérisé en ce qu'il comprend :

- en série entre l'entrée qui reçoit la puissance incidente et la sortie qui délivre la puissance de sortie, un premier coupleur, le dispositif à mesurer disposé dans un caisson à vide, un second coupleur ;
- et un mélangeur fonctionnant en détection de phase qui est relié, en sa première entrée, à une sortie du premier coupleur, qui correspond à un prélèvement d'une partie de la puissance incidente, au travers d'un premier atténuateur et d'un déphaseur et en sa seconde entrée à une sortie du second coupleur, qui correspond à un prélèvement d'une partie de la puissance de sortie, au travers d'un second atténuateur, et dont la sortie est reliée à un analyseur de spectre.

Les caractéristiques et avantages de l'invention ressortiront d'ailleurs de la description qui va suivre, à titre d'exemple non limitatif, en référence aux figures annexées sur lesquelles :

- la figure 1 illustre le dispositif de l'invention ;
- la figure 2 illustre une variante du dispositif de l'invention ;
- la figure 3 représente des courbes illlustrant le fonctionnement du dispositif de l'invention.

L'invention concerne un dispositif de mesure de l'effet multipactor par la mesure du bruit de phase induit.

Le dispositif de mesure comprend :

- en série entre l'entrée, qui reçoit la puissance incidente Pi, et la sortie, qui délivre la puissance de sortie Ps, un premier coupleur 10, le dispositif ou échantillon à mesurer 11, disposé dans un caisson à vide 12, un second coupleur 13 ;

- et un mélangeur 14 fonctionnant en détection de phase qui est relié, en sa première entrée, à une sortie du premier coupleur 10, qui permet un prélèvement d'une partie de la puissance incidente Pi, au travers d'un premier atténuateur 15 et d'un déphaseur 16, et en sa seconde entrée à une sortie du second coupleur 13 qui permet un prélèvement d'une partie de la puissance de sortie Ps, au travers d'un second atténuateur 17 ; et dont la sortie Vs est reliée à un analyseur de spectre 18 et à un voltmètre 19.

La mise en oeuvre du dispositif de mesure de l'invention consiste à prélever une partie du signal à l'entrée (Pi) et à la sortie (Ps) du dispositif à mesurer 11, les atténuateurs variables 15 et 17 ramenant les niveaux prélevés à des valeurs acceptables pour le mélangeur 14 utilisé ensuite, le déphaseur variable 16 étant inséré sur une des deux voies. Le mélangeur 14 reçoit donc deux signaux sur ses voies OL et RF, et est utilisé en tant que détecteurs de phase. La sortie (IF) du mélangeur est connectée à l'analyseur 18 de spectre basse fréquence (quelques Hz à quelques MHz). Le voltmètre 19 permet de mesurer la tension continue à la sortie du mélangeur 14.

La mesure consiste à agir sur les atténuateurs variable 15 et 17 de manière à avoir des niveaux compatibles avec le fonctionnement du mélangeur 14 en comparateur de phase. Le déphaseur variable 16 est alors réglé de manière à obtenir une tension continue nulle en sortie du mélangeur 14.

Lorsque l'effet multipactor se produit dans le dispositif à mesurer, il induit un bruit de phase sur le signal passant qui se traduit par une très forte augmentation du bruit mesuré à l'analyseur de spectre BF 18.

Cet analyseur de spectre BF 18 peut être remplacé par tout autre dispositif mesurant le bruit dans la gamme de fréquence 1 Hz à 1 MHz environ. L'analyseur de spectre ou le mesureur de bruit peut être précédé si nécessaire d'un amplificateur faible bruit de manière à augmenter la sensibilité de la mesure.

Le déphaseur 16 situé dans une des branches du mélangeur 14 permet de se situer dans la zône de plus grande sensibilité de celui-ci, en utilisant le voltmètre 19 par exemple pour obtenir un signal Vs nul.

L'analyseur de spectre BF 18 permet de réaliser une mesure du bruit de phase au pied de la porteuse pour une bande étroite de quelques Hz à quelques kilohertz (au maximum) autour du zéro.

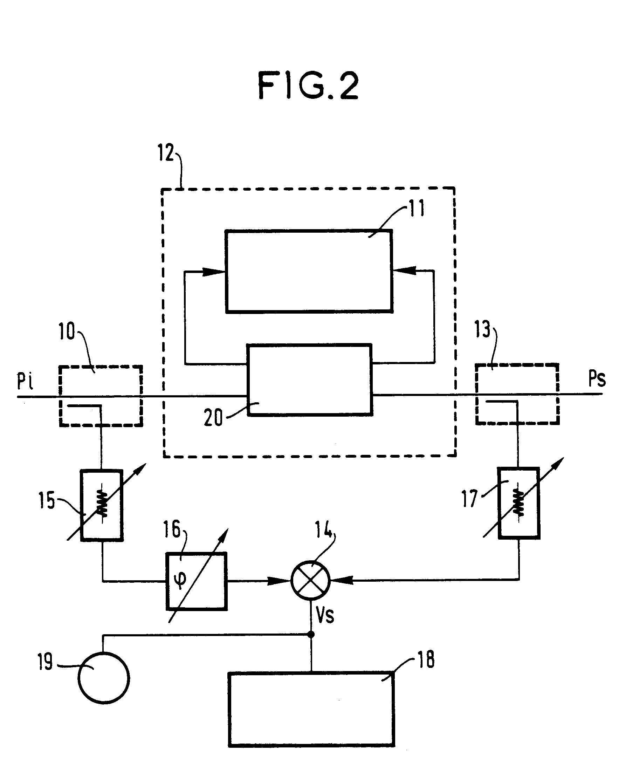

Une variante du dispositif de l'invention, représentée à la figure 2, comprend un anneau résonnant 20, dispositif connu de l'homme de l'art qui est formé d'une ligne en forme de boucle, résonnant à une fréquence donnée pour obtenir un gain.

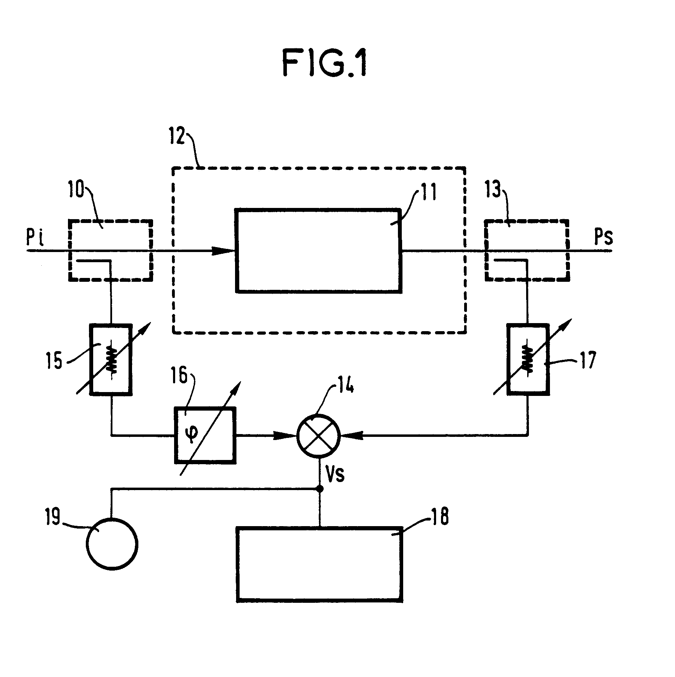

Le fonctionnement de cette variante reste le même que celui du dispositif représenté sur la figure 1, si ce n'est que l'anneau résonnant 20 permet, par ses propriétés, d'atteindre des puissances bien supérieures à la puissance incidente qui dépendent :

- des pertes du dispositif à mesurer ;
- des pertes propres de l'anneau résonnant ;
- du couplage à la ligne principale ;
- des pertes du coupleur.

La mesure de l'effet multipactor se fait toujours à basse puissance.

On utilise donc l'énergie stockée dans cet anneau résonnant 20 pour obtenir une puissance approximativement égale à la puissance incidente augmentée du couplage dû à l'anneau 20, si le dispositif à mesurer est faible perte (≤ 0,1 dB). On peut ainsi atteindre un gain de l'ordre de 10 dB ce qui, pour une puissance incidente de 500 W, permet d'atteindre dans l'échantillon une puissance de l'ordre de 5000 W ; un autre avantage de cet anneau 20 est que la puissance à l'intérieur de celui-ci est indépendante de la phase : tous les points de l'échantillon à mesurer voient donc la même puissance. Pour augmenter ou diminuer la fréquence de résonnance il suffit de diminuer ou augmenter la longueur de l'anneau.

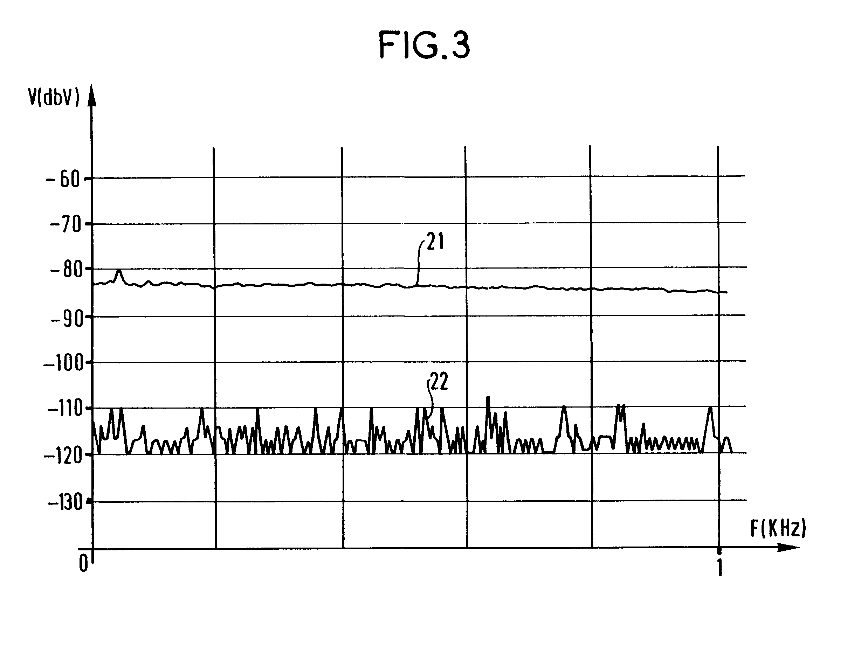

Avec un échantillon à mesurer 11 formé d'un morceau de guide d'onde de hauteur réduite (0,1 millimètre), utilisé pour se positionner au niveau multipactor, on obtient les courbes relevées sur l'analyseur de spectre 18 et représentées sur la figure 3, qui sont des courbes du niveau de bruit détecté en fonction de la fréquence F avec (21) on sans (22) effet multipactor.

La courbe 22 est donc une courbe relevée sans effet multipactor et la courbe 23 une courbe avec déclenchement dudit effet. Cette courbe présente un niveau moyen d'environ 40 dBV par rapport au bruit (courbe 22) avec les conditions de mesure suivantes :

- Pi = 55 à 58 dBm
- atténuation des coupleurs : 50 dB
- puissance maximum aux entrées du mélangeur : + 8 dBm
- fréquence : 11 GHz
- niveau de bruit de phase = -83 dBV
- niveau de référence : -120 dBV
- mesure sur 1 kHz
- tension mesurée du voltmètre : 0 volt.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1. Dispositif de mesure de l'effet multipactor, caractérisé en ce qu'il comprend :
   - en série entre l'entrée, qui reçoit la puissance incidente (Pi), et la sortie, qui délivre la puissance de sortie (Ps), un premier coupleur (10), le dispositif à mesurer (11) disposé dans un caisson à vide (12), un second coupleur (13) ;
   - et un mélangeur (14) fonctionnant en détection de phase qui est relié, en sa première entrée à une sortie du premier coupleur, qui permet un prélèvement d'une partie de la puissance incidente (Pi), au travers d'un premier atténuateur (15) et d'un déphaseur (16) et en sa seconde entrée à une sortie du second coupleur, qui permet un prélèvement d'une partie de la puissance de sortie (Ps), au travers d'un second atténuateur (17), et dont la sortie (Vs) est reliée à un mesureur de bruit (18).

2. Dispositif de mesure selon la revendication 1, caractérisé en ce qu'il comprend un anneau résonnant (20) permettant le couplage au dispositif à mesurer (11).

3. Dispositif selon l'une quelconque des revendications 1 ou 2, caractérisé en ce que le mesureur de bruit (18) est un analyseur de spectre basse fréquence.

4. Dispositif selon l'une quelconque des revendications précédentes caractérisé en ce qu'un amplificateur faible bruit est disposé entre le mélangeur (14) et le mesureur de bruit (18).

# FIG.1

# FIG.2

# FIG.3

EP 0 464 445 A1

**Office européen
des brevets**

# RAPPORT DE RECHERCHE
# EUROPEENNE

Numéro de la demande

**EP 91 10 9905**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A,D | MICROWAVE JOURNAL, mars 1978, pages 77-83; P.F. CLANCY: "Multipactor control in microwave space systems" * Page 82, colonne de gauche, colonne du milieu; figure 6 * – – – | 1,3 | G 01 R 29/26 G 01 R 31/26 |
| A | 15TH EUROPEAN MICROWAVE CONFERENCE, Paris, 9-13 septembre 1985, pages 483-488, Microwave Exhibitions and Publishers Ltd, Tunbridge Wells, Kent, GB; L.-G. BERNIER et al.: "A shifted reference receiver for the measurement of phase noise in microwave amplifiers" * Page 485, alinéas 2-4; figures 2-4 * – – – | 1 | |
| A | US-A-2 891 217  (ELECTRONIC RESEARCH) * Colonne 3, lignes 1-19; figure 1 * – – – – – | 1 | |

**DOMAINES TECHNIQUES
RECHERCHES (Int. Cl.5)**

G 01 R

Le présent rapport de recherche a été établi pour toutes les revendications

| Lieu de la recherche | Date d'achèvement de la recherche | Examinateur |
|---|---|---|
| La Haye | 17 septembre 91 | IWANSSON K.G. |

CATEGORIE DES DOCUMENTS CITES
X : particulièrement pertinent à lui seul
Y : particulièrement pertinent en combinaison avec un
   autre document de la même catégorie
A : arrière-plan technologique
O : divulgation non-écrite
P : document intercalaire
T : théorie ou principe à la base de l'invention

E : document de brevet antérieur, mais publié à la
   date de dépôt ou après cette date
D : cité dans la demande
L : cité pour d'autres raisons
------------------------------------------------
& : membre de la même famille, document
   correspondant